# EUROPÄISCHE PATENTANMELDUNG

(11) **EP 4 675 248 A1**
(43) Veröffentlichungstag der Anmeldung: **07.01.2026**
(21) Anmeldenummer: 25184744.8
(22) Anmeldetag: 24.06.2025
(51) Int. Cl.: G01M 99/00, G06K 7/00, G01N 3/20, G06K 19/07, G01N 3/32, G01M 5/00, G01R 31/00

(54) **VORRICHTUNG UND VERFAHREN ZUR PRÜFUNG EINER CHIPKARTE**

(30) Priorität: 04.07.2024 DE 102024119025
(71) Anmelder: Bundesdruckerei GmbH, 10969 Berlin (DE)
(72) Erfinder: Lesche, Ulrike, 13156 Berlin (DE); Voigt, Michael, 13581 Berlin (DE); Kliefoth, Rüdiger, 30952 Ronnenberg (DE)
(74) Vertreter: Hentrich Patent- & Rechtsanwaltspartnerschaft mbB

(57) **Zusammenfassung**

Die Erfindung betrifft eine Vorrichtung (1) zur Prüfung einer Chipkarte (2), mit einer Halteeinrichtung (5) zur Bereitstellung der Chipkarte (2) in einer ersten Prüfposition(6) zur Durchführung einer mechanischen Prüfung, und mit einer zweiten Prüfposition(7) zur Durchführung einer elektrischen Prüfung. Eine Transfereinrichtung (8) ist vorhanden, die ausgestaltet ist, um die Chipkarte (2) aus mindestens zwei unterschiedlichen Ausgangspositionen mittelbar oder unmittelbar an die Halteeinrichtung (5) zu übergeben. Die Erfindung betrifft weiterhin ein Verfahren zur Prüfung einer Chipkarte (2).

## Beschreibung

Die Erfindung betrifft eine Vorrichtung zur Prüfung einer Chipkarte, mit einer Halteeinrichtung zur Bereitstellung der Chipkarte in einer ersten Prüfposition zur Durchführung einer mechanischen Prüfung, und mit einer zweiten Prüfposition zur Durchführung einer elektrischen Prüfung, wobei eine Transfereinrichtung vorhanden ist, die ausgestaltet ist, um die Chipkarte aus mindestens zwei unterschiedlichen Ausgangspositionen mittelbar oder unmittelbar an die Halteeinrichtung zu übergeben. Die Erfindung betrifft weiterhin ein Verfahren zur Prüfung einer Chipkarte.

Unter Chipkarten werden Karten verstanden, die mit einem Chip versehen sind und somit ein elektrisches Bauteil, insbesondere zur Speicherung von Daten beinhalten. Derartige Chipkarten haben im alltäglichen Leben eine sehr weite Verbreitung gefunden. So werden Chipkarten beispielsweise für Kredit- oder Zahlkarten oder für Identitätsdokumente verwendet. Die Identitätsdokumente können dabei in unterschiedlichen Formaten vorliegen, die gemäß der ISO/IEC 7810 als ID-1, ID-2, ID-3 und ID-000 festgelegt sind. ID-2 entspricht dem Format DIN A7 und wird für deutsche Personalausweise verwendet. Aufgrund der Bedeutung dieser Chipkarten ist es erforderlich, dass diese über ihre gesamte zu erwartende Lebensdauer verlässlich funktionieren, wobei insbesondere bei Reisedokumenten die Gültigkeitsdauer mehrere Jahre, insbesondere 10 Jahre umfassen kann. Es sind daher Tests hinsichtlich des Verschleißes erforderlich, die sowohl die mechanischen Eigenschaften der Chipkarten überprüfen als auch Test hinsichtlich der Lesefähigkeit des Inhalts des der Karte zugeordneten Chips. Nach den Normen ISO/IEC 24789-2:2024 und ISO/IEC 10373-1:2020 werden für Reisedokumente mit Elektronikfunktion Beanspruchungstestsequenzen gefordert die als 3-Rollentest (3-wheel-test) bezeichnet werden. Eine Vorrichtung zur mechanischen Prüfung einer Chipkarte ist in der DE 695 20 634 T2 als deutsche Übersetzung der EP 0 704 819 B1 offenbart, die eine Testung gemäß ISI/IEC 10373 ermöglichen soll, wozu eine Chipkarte in eine Halteeinrichtung manuell eingelegt und durch eine zweite Einrichtung zum Positionieren und Verschieben bewegt wird, die die Karte entlang einer Druckrolle bewegt. Ein elektrischer Kartenleser kann an einem Totpunkt der Bewegung angeordnet sein, um in dieser Prüfposition die elektrische Funktionsfähigkeit der Karte bei jedem Durchlauf zu testen.

Nachteilig dabei ist, dass die Durchführung einer Vielzahl von Tests an mehreren Chipkarten sehr aufwändig ist und einen großen Personaleinsatz über einen langen Zeitraum erfordert.

Es ist daher die Aufgabe der vorliegenden Erfindung, eine Vorrichtung und ein Verfahren zum automatisierten Messen der Haltbarkeit der Chipkarte bereit zu stellen.

Diese Aufgabe wird durch eine Vorrichtung mit den Merkmalen des Anspruches 1 und durch ein Verfahren mit den Merkmalen des Anspruches 13 gelöst. Vorteilhafte Ausgestaltungen mit zweckmäßigen Weiterbildungen der Erfindung sind in den abhängigen Ansprüchen angegeben.

Die Vorrichtung der eingangs genannten Art bietet den Vorteil, dass eine erhöhte Flexibilität für die Durchführung der Test gegeben ist und insbesondere durch die Transfereinrichtung die Chipkarte zwischen unterschiedlichen Positionen bewegt und der Halteeinrichtung zugeführt werden kann, also unterschiedliche Schritte bei der Durchführung des Tests der Messung in der der ersten Prüfposition vorgeschaltet werden können. Eine Beschränkung hinsichtlich des Formats der Chipkarte ist dabei nicht gegeben, da in der Vorrichtung lediglich geometrische Anpassungen für unterschiedliche Kartenformate erforderlich sind.

Dabei ist es von Vorteil, wenn die Transfereinrichtung ausgestaltet ist, um die Chipkarte von der Halteeinrichtung an mindestens zwei unterschiedliche Ablagepositionen zu übergeben. Die steigert wiederum die Flexibilität und den Automatisierungsgrad, da nach der Durchführung der Messung die Chipkarte gezielt an die erwünschte und geeignete Position transferiert werden kann.

Eine nochmals weitere Steigerung der Flexibilität wird dadurch erreicht, dass eine dritte Ausgangspositionen vorhanden ist, dass eine dritte Ablageposition vorhanden ist, und dass die dritte Ausgangsposition und die dritte Ablageposition identisch und durch einen Kartenhalter zur senkrechten Zwischenlagerung der Chipkarte gebildet sind. Dieser Kartenhalter ermöglicht im Zusammenwirken mit der Transfereinrichtung, dass die Chipkarte auf beiden der Planseiten ergriffen werden kann, so dass die Chipkarte auch auf beiden der Planseiten für die Durchführung einer Messung abgelegt werden kann. Auch ist es möglich, eine als fehlerhaft erkannte Chipkarte dadurch zu drehen und so als fehlerhaft in einem Stapel von Chipkarten zu kennzeichnen.

Ganz besonders bevorzugt ist es, wenn die Transfereinrichtung durch einen Roboterarm gebildet ist, dem ein Greifer zugeordnet ist. Dieser Greifer kann als Sauggreifer oder Fingergreifer gestaltet sein, wobei hier wiederum der Sauggreifer bevorzugt ist. Der Roboterarm stellt eine sehr hohe Flexibilität hinsichtlich möglicher Ausgangspositionen und möglicher Ablagepositionen bereit, die auch beliebig als Startpunkt und als Endpunkt einer Bewegung kombiniert werden können, während eine Transfereinrichtung, die Steuerkurven zur Verstellung des Greifers nutzt, was prinzipiell möglich ist, durch die Steuerkurven vorgegebene feste Trajektorien beziehungsweise Pfade nutzen müsste.

Auch ganz besonders bevorzugt ist es, wenn eine Messstation vorhanden ist, die einen durch einen ersten Motor translatorisch verstellbaren Schlitten umfasst, dem eine die erste Prüfposition bildende Auflage zur randseitigen Abstützung der Chipkarte und die Halteeinrichtung zugeordnet ist, und wenn der Messstation ein Beanspruchungsglied zugeordnet ist, zu dem die Chipkarte durch den Schlitten in Kontakt gebracht werden kann. Mit einer derartigen Gestaltung lassen sich erste Beanspruchungstests zur Überprüfung des Verschleißes der Chipkarte durchführen, die eine Aussage über die Dauerbelastbarkeit ermöglichen. Die Aussagekraft beziehungsweise die Vergleichbarkeit der Testergebnisse ist aber begrenzt, da nicht zwingend normgerecht gemessen.

Um eine normgerechte Messung auswählbar bereit zu stellen, ist vorgesehen, dass das Beanspruchungsglied zur Ermöglichung eines 3-Rollentests aus einem Rollenpaar und einer höhenversetzt dem Rollenpaar gegenüberliegenden Einzelrolle gebildet ist, dass die Einzelrolle an der Unterseite eines oberen Querträgers angeordnet ist, der über zwei Koppelglieder mit einem unteren Querträger verbunden ist, auf dem eine Mehrzahl von Gewichten angeordnet ist, und dass das Rollenpaar auf einem mittleren Querträger angeordnet ist.

Die Messstation weist eine stationäre Halteplatte auf, an der mindestens ein Führungsglied angeordnet ist, auf dem durch einen zweiten Motor ein Lastaufnehmer höhenverstellbar angeordnet ist zum Anheben mindestens eines der Gewichte. Mit dieser Gestaltung kann die Beanspruchung der Chipkarte automatisiert variiert werden, so dass ganze Messzyklen an einer Chipkarte ohne Nutzereingriff durchgeführt werden können.

Um die Variation der Beanspruchung zu vereinfachen, weist jedes der Gewichte auf der dem Lastaufnehmer zugewandten Seite mindestens eine Aufnahme auf, wobei dem Lastaufnehmer mindestens ein Tragglied in einer zu der Aufnahme korrespondierenden Lage auf der den Gewichten zugewandten Seite angeordnet ist, und wobei durch einen dritten Motor der Lastaufnehmer zwischen einer Stellung, in der das Tragglied außer Eingriff mit der Aufnahme ist und einer Stellung, in der das Tragglied im Eingriff in der Aufnahme ist, verstellbar ist. Dadurch ergibt sich die Möglichkeit, gezielt eines der Gewichte aus dem Stapel der Gewichte anzuheben und so dessen Wirksamkeit, gemeinsam mit den oberhalb des ergriffenen Gewichts angeordneten Gewichten, bei der Beanspruchung der Chipkarte zu beenden.

Der Kontaktpunkt der drei Rollen auf der Chipkarte lässt sich variieren und an die Lage der Chipkarte anpassen, wenn auf der Halteplatte auf der dem Schlitten zugewandten Seite ein das Führungsglied umfassender Führungsträger angeordnet ist, der durch einen vierten Motor quer zu der Verstellrichtung des Schlittens verstellbar ist, und wenn der Führungsträger den mittlerer Querträger hält, der den oberen Querträger und den unteren Querträger über die Koppelglieder trägt und dadurch mit dem Führungsträger koppelt.

Es ist vorzugsweise auch ein fünfter Motor zur Höhenverstellung des Schlittens vorhanden, der eine Anpassung der Höhenlage des Schlittens und damit der Auflage an das Beanspruchungsglied ermöglicht.

Es ist die Wahl so getroffen, dass die erste Ausgangspositionen durch einen Bereitstellungsschacht für eine Chipkartenstapel gebildet ist, dass die erste Ablageposition durch einen Rücknahmeschacht für die Chipkarten nach dem Testende gebildet ist, dass die zweite Ausgangsposition und die zweite Ablageposition identisch und durch einen Kartenleser gebildet sind, der eine zweite Prüfposition für die Durchführung einer elektrischen Messung bildet.

Weiterhin ist vorzugsweise eine vierte Ablageposition, gebildet durch einen Schadkartenschacht, vorhanden. Diese Ausgangpositionen und Ablagepositionen können durch den Roboterarm beliebig als Startpunkt und Endpunkt einer Bewegung der Chipkarte kombiniert werden, so dass sich eine Vielzahl von Gestaltungsmöglichkeit bei der Durchführung der Tests ergibt. So kann nach einer Mehrzahl von Zyklen hinsichtlich der mechanischen Beanspruchung einer Messung durch den Kartenleser erfolgen und dann die Zyklen der mechanischen Beanspruchung fortgesetzt werden. Es kann die Chipkarte gedreht werden um ihre Längsachse. Weiterhin ist zu beachten, dass ein Wechsel der Beanspruchung durch eine Variation des Gewichts zwischen Zyklen durchgeführt werden kann, und zwar unabhängig von einer Bewegung der Chipkarte.

Die Halteeinrichtung weist einen auf dem Schlitten angeordneten Linearzylinder auf, durch den ein Klemmglied zur Klemmung der Chipkarte verstellbar ist, wobei die Chipkarte durch die Transfereinrichtung an die Halteeinrichtung in zwei um 90° um die Hochachse gedrehte Orientierungen übergebbar ist, wobei der Linearzylinder zweifach vorhanden ist, und wobei jeder der beiden Orientierungen einer der Linearzylinder zugeordnet ist. Mit dieser Gestaltung ist wiederum die Variationsmöglichkeit bei der Beanspruchung gesteigert, da die Chipkarte längs und quer zwischen die Rollen geführt werden, und zwar sowohl für die eine nach oben weisende Planseite als auch für die andere nach oben weisenden Planseite.

Auf dem Schlitten ist eine Säule mit einer Säulenplatte angeordnet, an der die Linearzylinder befestigt sind, die jeweils gelenkig mit einem im Mittenbereich abgestützten Hebel verbunden sind, der an seinem freien Ende das Klemmglied trägt. Diese Gestaltung zeichnet sich hinsichtlich der Einfachheit ihres Aufbaus aus, um mit dem Klemmglied reproduzierbar die gewünschte Klemmkraft zu erzielen.

Bei einem Verfahren zur Prüfung einer Chipkarte, bei dem die Chipkarte bei einer Mehrzahl von gegebenen Ausgangspositionen von einer der Ausgangsposition mit einer Transfereinrichtung ergriffen und mittelbar oder unmittelbar an eine Halteeinrichtung übergeben wird, besteht ein erhöhter Grad an Flexibilität, die die Halteeinrichtung mit der ersten Prüfposition eben nicht nur von einer Ausgangsposition, wie dem Bereitstellungsschacht, sondern auch von der zweiten Prüfposition oder dem Kartenhalter angefahren werden kann.

Auch ist es vorteilhaft, wenn die Chipkarte bei einer Mehrzahl von gegebenen Ablagepositionen von der Transfereinrichtung in einer der Ausgangspositionen ergriffen und an eine der Ablagepositionen transferiert wird. Dies ermöglicht in einfacher Weise die Einbindung des Kartenlesers in die Prüfprozedur oder das Ausscheiden von Chipkarten, die der Beanspruchung in dem Verschleißtest nicht stand gehalten haben in den Schadkartenschacht.

Der Zeitaufwand für die Prüfung einer Chipkarte wird reduziert, wenn nach dem Transferieren der Chipkarte mit der Transfereinrichtung von einer Ausgangsposition in eine Ablageposition eine mechanische oder elektrische Prüfung durchgeführt wird.

Eine direkte Verbindung ohne Zwischenablagen ist ermöglicht, wenn mit der Transfereinrichtung die Chipkarte zwischen einer ersten Prüfposition für die mechanische Prüfung und einer zweiten Prüfposition transferiert wird.

Es besteht eine hohe Flexibilität innerhalb des Verfahrens, wenn die mechanische Prüfung eine Applizierung einer mechanischen Beanspruchung beinhaltet, die wiederholt angewandt und/oder hinsichtlich einer Größe der Beanspruchung und/oder einer Orientierung der Chipkarte variiert werden kann.

Die vorstehend in der Beschreibung genannten Merkmale und Merkmalskombinationen sowie die nachfolgend in der Figurenbeschreibung genannten und/oder in der Figur alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen als von der Erfindung umfasst und offenbart anzusehen, die in der Figur nicht explizit gezeigt oder erläutert sind, jedoch durch separierte Merkmalskombinationen aus den erläuterten Ausführungen hervorgehen und erzeugbar sind.

Weitere Vorteile, Merkmale und Einzelheiten der Erfindung ergeben sich aus den Ansprüchen, der nachfolgenden Beschreibung bevorzugter Ausführungsformen sowie anhand der Zeichnung. Dabei zeigt:
- Fig. 1: eine perspektivische Ansicht der Trägerplatte der Vorrichtung mit den zugeordneten Baugruppen,
- Fig. 2: eine Draufsicht auf den Gegenstand von Figur 1,

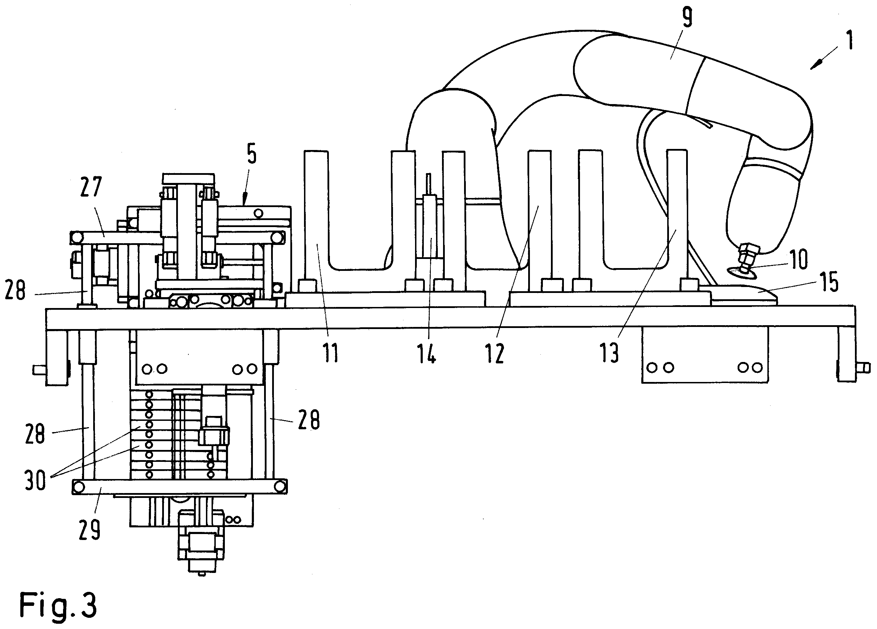

- Fig. 3: eine Sicht aus Richtung des Pfeiles III aus Figur 1,
- Fig. 4: eine perspektivische Ansicht der Baugruppe zur Durchführung der mechanischen Messung,

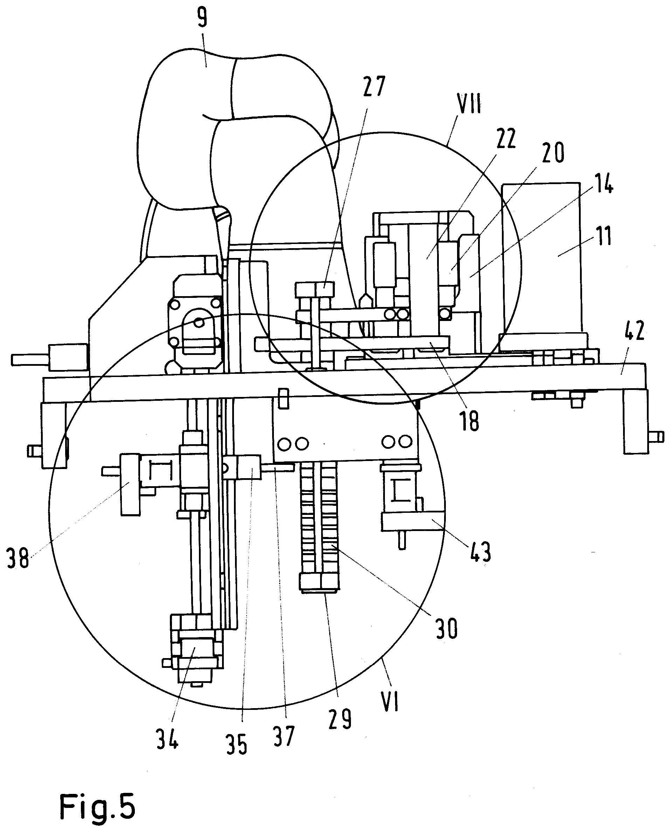

- Fig. 5: eine Sicht aus Richtung des Pfeiles IV aus Figur 1,
- Fig. 6: das Detail VI aus Figur 5,

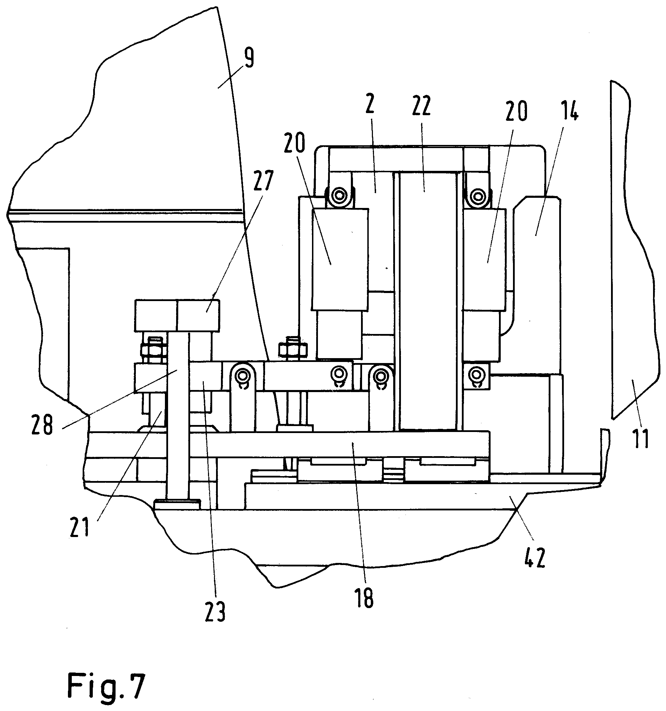

- Fig. 7: das Detail VII aus Figur 5, und
- Fig. 8: eine perspektivische Ansicht der Vorrichtung mit ihrem in einem Gehäuse eingefassten Gestell.

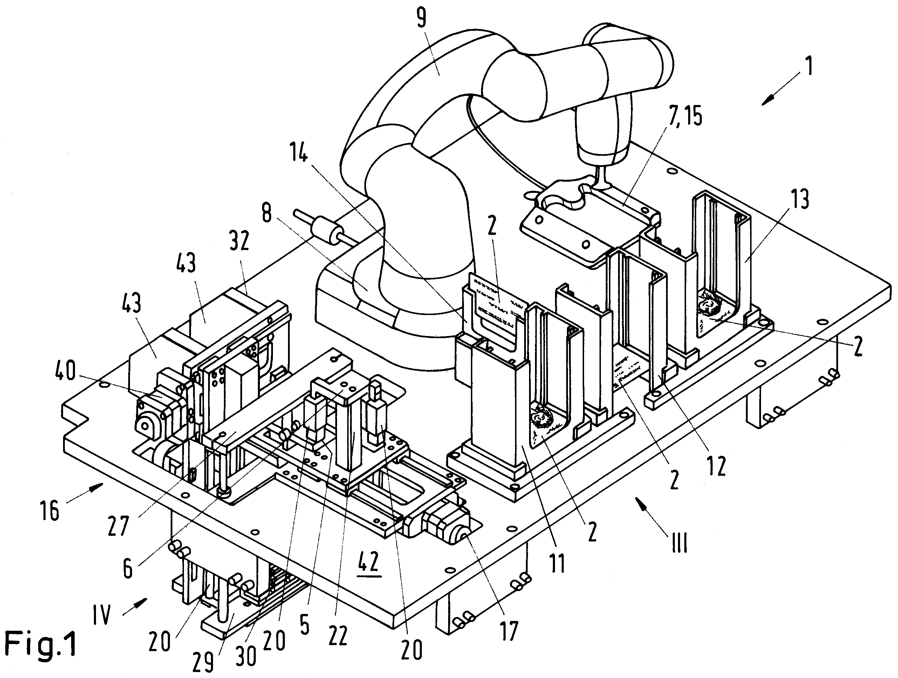

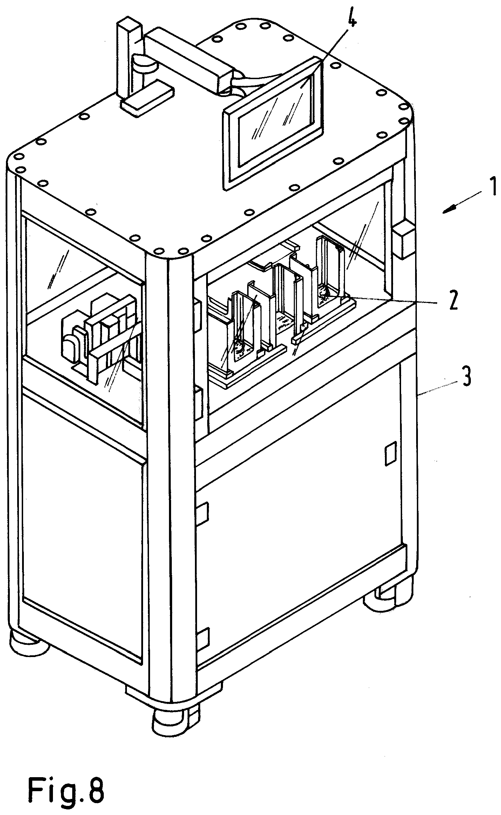

In der Figur 1 ist eine Vorrichtung 1 zur Prüfung einer Chipkarte 2 gezeigt; diese Vorrichtung 1 ist in der Regel auf einem Gestell angeordnet, das in dem aus der Figur 8 ersichtlichen Gehäuse 3 eingefasst ist. Dieses Gehäuse 3 kann stationär auf Standfüßen angeordnet oder auf Rollen verschiebbar gelagert sein. In dem Gehäuse 3 sind die zum Betrieb der Vorrichtung 1 erforderlichen Nebenaggregate angeordnet, so wie eine Spannungsversorgung zur Bereitstellung elektrischer Energie und eine Steuerungseinrichtung, die insbesondere durch einen Computer gebildet sein kann. Gezeigt in der Figur 8 ist auch ein Bildschirm 4, der in einer Ausgestaltung als Touch-Screen zugleich auch als Eingabegerät dienen kann.

Die erfindungsgemäße Vorrichtung 1 weist eine Halteeinrichtung 5 zur Bereitstellung der Chipkarte 2 in einer ersten Prüfposition 6 zur Durchführung einer mechanischen Prüfung auf. Des Weiteren ist auch eine zweite Prüfposition 7 zur Durchführung einer elektrischen Prüfung vorhanden. Von besonderer Bedeutung ist dabei eine Transfereinrichtung 8, die zum gezielten Bewegen einer Chipkarte 2 innerhalb der Vorrichtung 1 dient. In den gezeigten Ausführungsbeispiel ist die Transfereinrichtung 8 durch einen Roboterarm 9 gebildet, bei dem an seinem freien Ende ein Greifer 10 zum Ergreifen und Halten der Chipkarte 2 angeordnet ist. In der gezeigten Ausführungsform ist der Greifer 10 als Sauggreifer realisiert, jedoch ist auch die Nutzung eines Fingergreifers denkbar. Der Roboterarm 9 kann durch einen Cobot gegeben sein, also einen kollaborativen Roboter, der keine Gefährdung für einen die Vorrichtung 1 bedienenden Menschen darstellt.

In der Figur 1 ist weiterhin gezeigt ein Bereitstellungsschacht 11 für mindestens eine Chipkarte 2, der auch eine Mehrzahl von Chipkarten 2 in einem Chipkartenstapel aufnehmen kann. Ein Rücknahmeschacht 12 dient der Rücknahme der Chipkarte 2 nach dem Testende, sofern diese den Test fehlerfrei überstanden hat. Vorhanden ist auch ein Schadkartenschacht 13, in den die die Chipkarten 2 zurückgegeben werden, bei denen im Verlauf des Tests ein Fehler detektiert wurde. Die Vorrichtung 1 verfügt weiterhin über einen Kartenhalter 14 zur senkrechten Zwischenlagerung der Chipkarte 2.

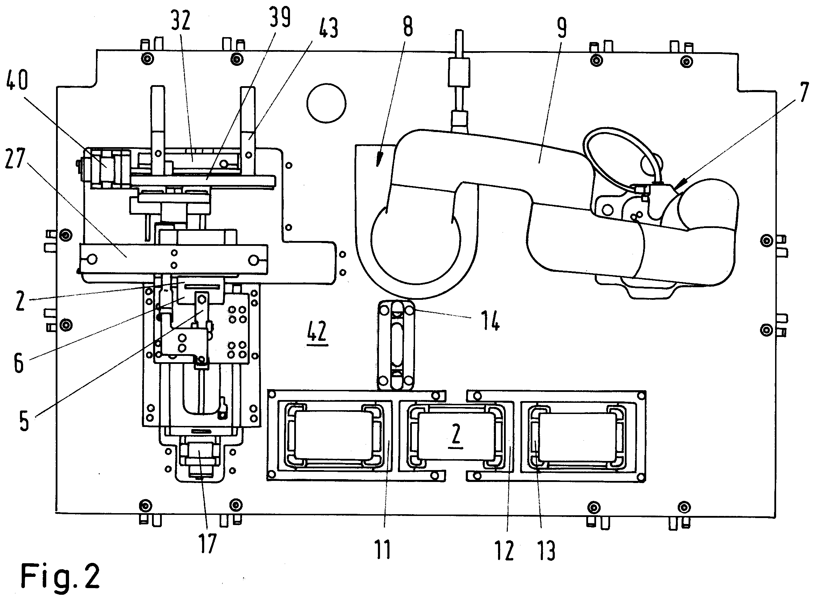

Gezeigt in der Figur 1 ist die Halteeinrichtung 5, durch die die Chipkarte 2 in der ersten Prüfposition 6 zur Durchführung einer mechanischen Prüfung gehalten und gesichert wird. Ein Kartenleser 15 stellt die zweite Prüfposition 7 zur Durchführung der elektrischen Prüfung dar. Die Figur 2 zeigt die Draufsicht und Anordnung der ersten Prüfposition 6, der zweiten Prüfposition 7, der drei Schächte für die Chipkarten 2 und den Kartenhalter 14.

Der Bereitstellungsschacht 11 bildet dabei eine erste Ausgangsposition als Startpunkt, in der der Roboterarm 9 eine Chipkarte 2 aus dem Chipkartenstapel dem Bereitstellungsschacht 11 entnehmen und zu einem gewünschten Ort transferieren kann. Die erste Ablageposition ist durch den Rücknahmeschacht 12 für die Chipkarten 2 gebildet.

Der Kartenleser 15 bildet sowohl eine zweite Ausgangsposition als auch eine zweite Ablageposition, da eine Chipkarte 2 beispielsweise aus dem Bereitstellungsschacht 11 entnommen und an den Kartenleser 14 übergeben werden kann, um zu überprüfen, ob zu Beginn des Tests die Chipkarte 2 die gewünschten elektrischen Eigenschaften aufweist. Von diesem Kartenleser 15 als zweite Ablageposition kann die Chipkarte 2 dann direkt an die Halteeinrichtung 5 übergeben werden, so dass der Kartenleser 14 in diesem Zusammenhang als zweite Ausgangposition fungiert.

Es ist darauf hinzuweisen, dass die Halteeinrichtung 5 aber auch direkt aus dem Bereitstellungsschacht 11 mit der Chipkarte 2 bestückt werden kann.

Der Kartenhalter 14 zur senkrechten Zwischenlagerung bildet eine dritte Ausgangsposition und eine dritte Ablageposition, da aus dem Bereitstellungsschacht 11 oder von der Halteeinrichtung 5 oder dem Kartenleser 15 die Chipkarte 2 an den Kartenhalter 14 durch den Roboterarm 9 übergeben werden kann. Dadurch ergibt sich die Möglichkeit, dass der Roboterarm 9 nach der Übergabe der Chipkarte 2 an den Kartenhalter 14 die Chipkarte 2 auf der anderen Seite ergreift und sodann aus dem Kartenhalter 14 wegbewegt zu der Halteeinrichtung 5, sodass die Chipkarte 2 in der Halteeinrichtung 5 mit einer um 180° um die Längsachse gedrehten Orientierung gehalten wird, also die andere Planseite nach oben weist. Der Kartenhalter 14 ist damit Endpunkt einer Bewegung der Chipkarte 2 durch den Roboterarm 9 und auch Ausgangspunkt der Bewegung der Chipkarte 2 durch den Roboterarm 9, wenn dieser die Chipkarte 2 auf der gegenüberliegenden Seite im Vergleich zu der Übergabe ergreift.

Aus dem vorstehend geschilderten ergibt sich, dass für die Chipkarte 2 vielfältige Bewegungspfade erforderlich sind und sich damit ein komplexes Bewegungsmuster ergibt, dessen Realisierung am einfachsten durch den die Transfereinrichtungen 8 bildenden Roboterarm 9 ermöglicht ist.

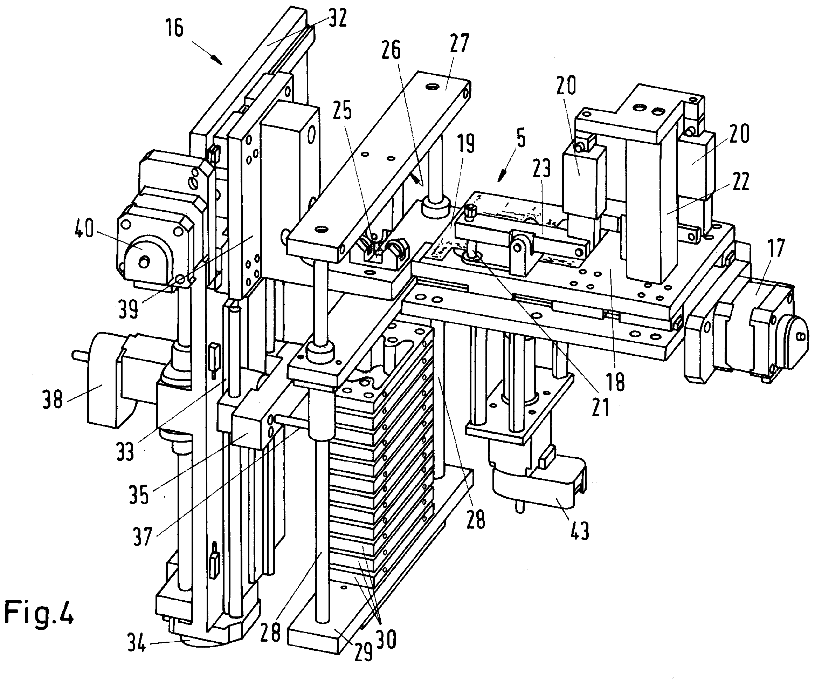

Die Figur 1 zeigt auch die Positionierung einer Messstation 16 innerhalb der Vorrichtung 1. Diese Messstation 16 ist in der Figur 4 isoliert dargestellt.

Diese Messstation 16 umfasst einen durch einen ersten Motor 17 translatorisch verstellbaren Schlitten 18, dem eine die erste Prüfposition6 bildende Auflage 19 zur randseitigen Abstützung der Chipkarte 2 durch die Halteeinrichtung 5 zugeordnet ist. Die Haltereinrichtung 5 weist einen auf dem Schlitten 18 angeordneten Linearzylinder 20 auf, durch den ein Klemmglied 21 zur Klemmung der Chipkarte 2 gegenüber der Auflage 19 verstellbar ist.

Die Nutzung eines Roboterarms 9 als Transfereinrichtung 8 ermöglicht auch, dass die Chipkarte 2 an die Halteeinrichtung 5 in zwei unterschiedliche, um 90° um die Hochachse gedrehte Orientierungen übergebbar ist. Der Linearzylinder 20 ist daher zweifach vorhanden, wobei jeder der beiden Orientierungen einer der Linearzylinder 20 zugeordnet ist. Auf dem Schlitten 18 ist eine Säule 22 mit einer Säulenplatte angeordnet, an der die Linearzylinder 20 befestigt sind. Die Linearzylinder 20 sind jeweils gelenkig mit einem im Mittenbereich abgestützten Hebel 23verbunden, der an seinem freien Ende das Klemmglied 21 trägt.

Der Messstation 16 ist ein Beanspruchungsglied 24 zugeordnet, mit dem die Chipkarte 2 durch den Schlitten 18 in Kontakt gebracht werden kann.

Das Beanspruchungsglied 24 ist in dem gezeigten Ausführungsbeispiel zur Ermöglichung eines 3-Rollentests aus einem Rollenpaar 25 und einer höhenversetzt dem Rollenpaar 25 gegenüberliegenden Einzelrolle 26 gebildet. Dabei ist die Einzelrolle 26 an der Unterseite eines oberen Querträgers 27 angeordnet, der über zwei Koppelglieder 28 mit einem unteren Querträger 29 verbunden ist, auf dem eine Mehrzahl von Gewichten 30 angeordnet ist. Die Gewichte 30 besitzen dabei auf ihrer Unterseite Strukturen, die formschlüssig mit komplementären Strukturen auf der Oberseite des benachbarten Gewichts 30 verbunden werden können. Beispielhaft kann dazu auf Nocken und Nockenaufnahmen verwiesen werden. Das Rollenpaar 25 ist auf einem mittleren Querträger 31 angeordnet.

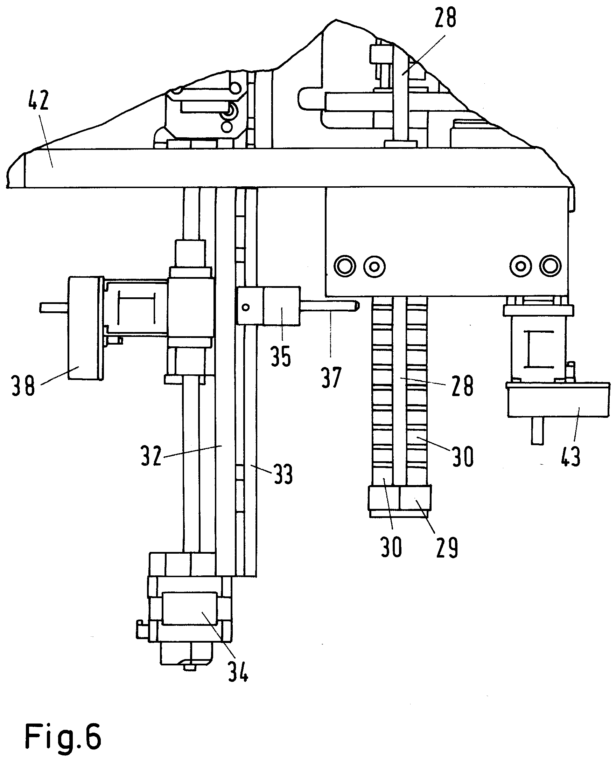

Die Messstation 16 weist eine stationäre Halteplatte 32 auf, an der mindestens ein Führungsglied 33 angeordnet ist, auf dem durch einen zweiten Motor 34 ein Lastaufnehmer 35 höhenverstellbar angeordnet ist zum Anheben mindestens eines der Gewichte 30. Die Figur 6 zeigt die vorstehend genannten Einzelheiten im Detail.

Jedes der Gewichte 30 weist auf der dem Lastaufnehmer 35 zugewandten Seite mindestens eine Aufnahme 36 auf, wobei in dem gezeigten Ausführungsbeispiel jeweils zwei Aufnahmen 36 an dem Gewicht 30 ausgebildet sind in der Gestalt als Bohrungen.

An dem Lastaufnehmer 35 ist mindestens ein Tragglied 37 in einer zu der Aufnahme 36 korrespondierenden Lage auf der den Gewichten 30 zugewandten Seite angeordnet. In der gezeigten Ausführungsform ist zum Zusammenwirken mit den beiden Bohrungen das Tragglied 37 zweifach vorgesehen in der Gestaltung als Stifte, die in die Bohrungen eingeführt werden können. Dazu ist ein dritter Motor 38 vorgesehen, durch den der Lastaufnehmer 35 zwischen einer ersten Stellung, in der die Tragglieder 37 außer Eingriff mit den Bohrungen der auf dem unteren Querträger 29 angeordneten Gewicht 30 ist, und einer zweiten Stellung, in der die Tragglieder 37 im Eingriff mit den Bohrungen sind, verstellbar ist.

Auf der Halteplatte 32 ist auf der dem Schlitten 18 zugewandten Seite ein das Führungsglied 33 umfassender Führungsträger 39 angeordnet, der durch einen vierten Motor 40 quer zu der Verstellrichtung des Schlittens 18 verstellbar ist. Der Führungsträger 39 hält den mittleren Querträger 31, der den oberen Querträger 27 und den unteren Querträger 29 über die Koppelglieder 28 trägt und dadurch mit dem Führungsträger 39 koppelt.

Die Figur 4 lässt auch erkennen, dass ein fünfter Motor 41 zur Höhenverstellung des Schlittens 18 gegenüber einer Platte vorhanden ist, die der Befestigung gegenüber einer Bodenplatte 42 der Vorrichtung 1 dient. Die stationäre Halteplatte 32 ist durch mindestens einen Halteblock 43, in dem gezeigten Ausführungsbeispiel durch zwei Halteblöcke 43, an der Bodenplatte 42 befestigt.

Im Folgenden wird nun noch die Durchführung des Verfahrens zur Prüfung einer Chipkarte unter Nutzung der Vorrichtung 1 zur Prüfung einer Chipkarte 2 geschildert. Ausgangspunkt ist dabei ein in dem Bereitstellungsschacht 11 angeordneter Stapel von Chipkarten 2, wobei die oberste Chipkarte 2 von der durch den Roboterarm 9 gebildeten Transfereinrichtung 8 mittels des Sauggreifers ergriffen werden kann. Diese Chipkarte 2 kann von dem Roboterarm 9 zunächst dem Kartenleser 15 zugeführt werden, um die elektrische Funktionsfähigkeit der Chipkarte 2 zu Beginn des Testes zu überprüfen. Von dort kann die Chipkarte 2 durch den Roboterarm 9 an die Halteeinrichtung 5 in der ersten Prüfposition6 zur Durchführung der mechanischen Prüfung übergeben werden. Die erste Prüfposition kann dabei auch als fünfte Ablageposition aufgefasst werden. Es ist selbstverständlich auch möglich, die Chipkarte 2 direkt aus dem Bereitstellungsschacht 11 an die Halteeinrichtung 5 zu übergeben, sodass die Chipkarte 2 aus mindestens zwei unterschiedlichen Ausgangspositionen mittelbar oder unmittelbar an die Halteeinrichtung 5 übergeben werden kann.

In der ersten Prüfposition6 wird die Chipkarte 2 durch das von dem Linearzylinder 20 betätigte Klemmglied 21 randseitig geklemmt. Anschließend wird die mechanische Prüfung durchgeführt, indem die Chipkarte 2 durch die translatorische Verstellung des Schlittens 18 dem Beanspruchungsglied 24 zugeführt wird. In dem gezeigten Ausführungsbeispiel ist das Beanspruchungsglied 21 durch das Rollenpaar 25 und die Einzelrolle 26 gebildet. Zwischen dem Rollenpaar 25 und der Einzelrolle 26 wird die Chipkarte 2 hin und her geführt, wobei die Anzahl der Zyklen vorgebbar und variierbar ist.

Die auf die Chipkarte 2 wirkende Beanspruchung ist bestimmt durch die wirkende Gewichtskraft mit den auf dem unteren Querträger 29 angeordneten Gewichten 30. Um die wirkende Beanspruchung variieren zu können, insbesondere in aufeinanderfolgenden Schritten beziehungsweise in aufeinanderfolgen Testzyklen erhöhen zu können, besteht die Möglichkeit, die insgesamt variierende Gewichtskraft zu verändern. Dazu wird durch den zweiten Motor 34 der Lastaufnehmer 35 hinsichtlich seiner Höhenlage verstellt und durch den dritten Motor 38 aus der ersten Stellung, in der die Stifte nicht im Eingriff mit den Bohrungen sind, in die zweite Stellung verstellt, in der die Stifte in Eingriff mit den Bohrungen sind. Durch den zweiten Motor 34 kann dann ein Anheben des Lastaufnehmers 35 erfolgen, sodass dadurch das auf den Stiften steckende Gewicht 30, sowie die gegebenenfalls darüber befindlichen Gewichte 30, von den darunterliegenden, auf dem unteren Querträger 29 angeordneten Gewichten 30 angehoben werden und den unteren Querträger 29 nicht mehr belasten.

Der Lastaufnehmer 35 kann durch den dritten Motor 38 mit den auf den Stiften angeordneten Gewichten 30 in die erste Stellung zurückgezogen werden. Mit der veränderten Anzahl an Gewichten 30 auf dem unteren Querträger 29 kann der Beanspruchungstest durch erneute translatorische Verstellung des Schlittens 18 wiederholt bzw. ergänzt werden.

Soll erneut die Gewichtskraft variiert werden, so kann das auf den Stiften angeordnete Gewicht 30 zunächst zu dem unteren Querträger 29 zurückgeführt und dort auf dem unteren Querträger 29 unmittelbar oder auch auf diesem gelagerten Gewichten 30 abgelegt werden. Die Stifte werden sodann aus den Aufnahmen des Gewichtes 30 durch eine Verstellung mittels des dritten Motors 38 zurückgezogen. Durch den zweiten Motor 34 kann die Höhenlage des Lastaufnehmers 35 eingenommen werden, die mit der gewünschten neuen Gewichtskraft korrespondiert. Der Vorgang wird dann in der zuvor geschilderten Weise wiederholt.

Es ist darauf hinzuweisen, dass nach einer bestimmten Anzahl der translatorischen Verstellungen der Chipkarte 2 durch den Schlitten 18 ein Überprüfen der elektrischen Funktionsfähigkeit der Chipkarte 2 erfolgen kann, indem die Chipkarte 2 von der ersten Prüfposition6 in die zweite Prüfposition7 geführt wird. Von dieser zweiten Prüfposition7 kann die Chipkarte 2 unmittelbar wieder an die erste Prüfposition6 zurückgegeben werden. Eine derartige Durchführung der elektrischen Prüfung ist dabei nicht nur nach einer vorgegebenen Anzahl von Zyklen der translatorischen Verstellung möglich, sondern auch zu einem Gewichtswechsel.

Die Chipkarte 2 kann durch den Roboterarm 9 mit seinem Sauggreifer auch aus der ersten Prüfposition 6 entnommen und an den Kartenhalter 14 zur senkrechten Zwischenlagerung der Chipkarte 2 übergeben werden. Der Sauggreifer des Roboterarms 9 kann dann die Chipkarte 2 von der anderen Seite ergreifen und sodann in der ersten Prüfposition 6 wieder ablegen, sodass die mechanische Prüfung auch in dieser Orientierung der Chipkarte 2 durchgeführt werden kann.

Möglich ist es auch, dass die Chipkarte 2 durch den Roboterarm 9 an die Halteeinrichtung 5 in einer um 90° um die Hochachse gedrehten Orientierung übergeben wird. In dieser Orientierung, in der beispielsweise anstatt der Breitseite die Längsseite der Chipkarte 2 zwischen die Einzelrolle 26 und das Rollenpaar 25 geführt wird, wird der andere Linearzylinder 20 zu Betätigung des Klemmgliedes 21 genutzt.

Durch die Drehung der Chipkarte 2 kommt der auf der Chipkarte 2 angeordnete Chip in einer anderen Stellung in der ersten Prüfposition 6 zu liegen. Um dies berücksichtigen zu können, wird durch den vierten Motor 40 der Führungsträger 39 quer zu der Verstellrichtung des Schlittens 18 verschoben, um eine korrekte Positionierung des Rollenpaares 25 und der Einzelrollen sicherstellen zu können.

Die Vorrichtung 1 ermöglicht damit eine automatisierte Durchführung des Tests einer Mehrzahl von Chipkarten 2, wobei die Anordnung der Chipkarten 2 in der ersten Prüfposition 6 variiert werden kann hinsichtlich einer Drehung um die Längsachse, mithilfe des Kartenhalters 14, und einer Drehung um die Hochachse mithilfe des Roboterarms 9. Variiert werden kann die Anzahl der Zyklen, die mit dem Schlitten 18 ausgeführt werden. Variiert werden kann auch die Beanspruchung durch einen automatisierten Wechsel der Gewichte 30, wobei nach Abschluss des Tests je nach Ergebnis die getestete Chipkarte 2 an den Rücknahmeschacht 12 oder den Schadkartenschacht 13 übergeben werden kann.

### BEZUGSZEICHENLISTE:

- 1: Vorrichtung
- 2: Chipkarte
- 3: Gehäuse
- 4: Bildschirm
- 5: Halteeinrichtung
- 6: erste Prüfposition
- 7: zweite Prüfposition
- 8: Transfereinrichtung
- 9: Roboterarm
- 10: Greifer
- 11: Bereitstellungsschacht
- 12: Rücknahmeschacht
- 13: Schadkartenschacht
- 14: Kartenhalter
- 15: Kartenleser
- 16: Messstation
- 17: erster Motor
- 18: Schlitten
- 19: Auflage
- 20: Linearzylinder
- 21: Klemmglied
- 22: Säule
- 23: Hebel
- 24: Beanspruchungsglied
- 25: Rollenpaar
- 26: Einzelrolle
- 27: oberer Querträger
- 28: Koppelglieder
- 29: unterer Querträger
- 30: Gewicht
- 31: mittlerer Querträger
- 32: Halteplatte
- 33: Führungsglied
- 34: zweiter Motor
- 35: Lastaufnehmer
- 36: Aufnahme
- 37: Tragglied
- 38: dritter Motor
- 39: Führungsträger
- 40: vierter Motor
- 41: fünfter Motor
- 42: Bodenplatte

## Patentansprüche

1. Vorrichtung (1) zur Prüfung einer Chipkarte (2), mit einer Halteeinrichtung (5) zur Bereitstellung der Chipkarte (2) in einer ersten Prüfposition (6) zur Durchführung einer mechanischen Prüfung, und mit einer zweiten Prüfposition (7) zur Durchführung einer elektrischen Prüfung, **dadurch gekennzeichnet, dass** eine Transfereinrichtung (8) vorhanden ist, die ausgestaltet ist, um die Chipkarte (2) aus mindestens zwei unterschiedlichen Ausgangspositionen mittelbar oder unmittelbar an die Halteeinrichtung (5) zu übergeben.

2. Vorrichtung (1) nach Anspruch 1, **dadurch gekennzeichnet, dass** die Transfereinrichtung (8) ausgestaltet ist, um die Chipkarte (2) von der Halteeinrichtung (5) an mindestens zwei unterschiedliche Ablagepositionen zu übergeben.

3. Vorrichtung (1) nach Anspruch 2, **dadurch gekennzeichnet, dass** eine dritte Ausgangsposition vorhanden ist, dass eine dritte Ablageposition vorhanden ist, und dass die dritte Ausgangsposition und die dritte Ablageposition identisch und durch einen Kartenhalter (14) zur senkrechten Zwischenlagerung der Chipkarte (2) gebildet sind.

4. Vorrichtung (1) nach einem der Ansprüche 1 bis 3, **dadurch gekennzeichnet, dass** eine Messstation (16) vorhanden ist, die einen durch einen ersten Motor (17) translatorisch verstellbaren Schlitten (18) umfasst, dem eine die erste Prüfposition(6) bildende Auflage (19) zur randseitigen Abstützung der Chipkarte (2) und die Halteeinrichtung (5) zugeordnet ist, und dass der Messstation (16) ein Beanspruchungsglied (24) zugeordnet ist, zu dem die Chipkarte (2) durch den Schlitten (18) in Kontakt gebracht werden kann.

5. Vorrichtung (1) nach Anspruch 4, **dadurch gekennzeichnet, dass** das Beanspruchungsglied (24) zur Ermöglichung eines 3-Rollentests aus einem Rollenpaar (25) und einer höhenversetzt dem Rollenpaar (25) gegenüberliegenden Einzelrolle (26) gebildet ist, dass die Einzelrolle (26) an der Unterseite eines oberen Querträgers (27) angeordnet ist, der über zwei Koppelglieder (28) mit einem unteren Querträger (29) verbunden ist, auf dem eine Mehrzahl von Gewichten (30) angeordnet ist, und dass das Rollenpaar (25) auf einem mittleren Querträger (31) angeordnet ist.

6. Vorrichtung (1) nach Anspruch 5, **dadurch gekennzeichnet, dass** die Messstation (16) eine stationäre Halteplatte (32) aufweist, an der mindestens ein Führungsglied (33) angeordnet ist, auf dem durch einen zweiten Motor (34) ein Lastaufnehmer (35) höhenverstellbar angeordnet ist zum Anheben mindestens eines der Gewichte (30).

7. Vorrichtung (1) nach Anspruch 6, **dadurch gekennzeichnet, dass** jedes der Gewichte (30) auf der dem Lastaufnehmer (35) zugewandten Seite mindestens eine Aufnahme aufweist, dass dem Lastaufnehmer (35) mindestens ein Tragglied (37) in einer zu der Aufnahme korrespondierenden Lage auf der den Gewichten (30) zugewandten Seite angeordnet ist, und dass durch einen dritten Motor (38) der Lastaufnehmer (35) zwischen einer Stellung, in der das Tragglied außer Eingriff mit der Aufnahme ist und einer Stellung, in der das Tragglied im Eingriff in der Aufnahme ist, verstellbar ist.

8. Vorrichtung (1) nach Anspruch 6 oder 7, **dadurch gekennzeichnet, dass** auf der Halteplatte (32) auf der dem Schlitten (18) zugewandten Seite ein das Führungsglied (33) umfassender Führungsträger (39) angeordnet ist, der durch einen vierten Motor (40) quer zu der Verstellrichtung des Schlittens (18) verstellbar ist, und dass der Führungsträger (39) den mittlerer Querträger (31) hält, der den oberen Querträger (27) und den unteren Querträger (29) über die Koppelglieder (28) trägt und dadurch mit dem Führungsträger (39) koppelt.

9. Vorrichtung (1) nach einem der Ansprüche 3 bis 8, **dadurch gekennzeichnet, dass** die erste Ausgangspositionen durch einen Bereitstellungsschacht (11) für eine Chipkartenstapel gebildet ist, dass die erste Ablageposition durch einen Rücknahmeschacht (12) für die Chipkarten (2) nach dem Testende gebildet ist, dass die zweite Ausgangsposition und die zweite Ablageposition identisch und durch einen Kartenleser (14) gebildet sind, der eine zweite Prüfposition(7) für die Durchführung einer elektrischen Messung bildet.

10. Vorrichtung (1) nach einem der Ansprüche 4 bis 9, **dadurch gekennzeichnet, dass** die Halteeinrichtung (5) einen auf dem Schlitten (18) angeordneten Linearzylinder (20) aufweist, durch den ein Klemmglied (21) zur Klemmung der Chipkarte (2) verstellbar ist.

11. Vorrichtung (1) nach Anspruch 10, **dadurch gekennzeichnet, dass** die Chipkarte (2) durch die Transfereinrichtung (8) an die Halteeinrichtung (5) in zwei um 90° um die Hochachse gedrehte Orientierungen übergebbar ist, dass der Linearzylinder (20) zweifach vorhanden ist, und dass jeder der beiden Orientierungen einer der Linearzylinder (20) zugeordnet ist.

12. Vorrichtung (1) nach Anspruch 11, **dadurch gekennzeichnet, dass** auf dem Schlitten (18) eine Säule (22) mit einer Säulenplatte angeordnet ist, an der die Linearzylinder (20) befestigt sind, die jeweils gelenkig mit einem im Mittenbereich abgestützten Hebel (23) verbunden sind, der an seinem freien Ende das Klemmglied (21) trägt.

13. Verfahren zur Prüfung einer Chipkarte (2), bei dem die Chipkarte (2) bei einer Mehrzahl von gegebenen Ausgangspositionen von einer der Ausgangsposition mit einer Transfereinrichtung (8) ergriffen und mittelbar oder unmittelbar an eine Halteeinrichtung (5) übergeben wird.

14. Verfahren nach Anspruch 13, **dadurch gekennzeichnet, dass** nach dem Transferieren der Chipkarte (2) mit der Transfereinrichtung (8) von einer Ausgangsposition in eine Ablageposition eine mechanische oder elektrische Prüfung durchgeführt wird.

15. Verfahren nach Anspruch 14, **dadurch gekennzeichnet, dass** die mechanische Prüfung eine Applizierung einer mechanischen Beanspruchung beinhaltet, die wiederholt angewandt und/oder hinsichtlich einer Größe der Beanspruchung und/oder einer Orientierung der Chipkarte (2) variiert wird.
